# EUROPÄISCHE PATENTSCHRIFT

(11) **EP 0 448 077 B1**
(45) Veröffentlichungstag und Bekanntmachung des Hinweises auf die Patenterteilung: **16.08.1995**
(21) Anmeldenummer: 91104340.4
(22) Anmeldetag: 20.03.1991
(51) Int. Cl.: H05H 1/46, H05H 1/18, H01J 37/32

(54) **Mikrowellen-Plasmatron**
Microwave plasmatron
Plasmatron à micro-ondes

(30) Priorität: 20.03.1990 DD 338878
(43) Veröffentlichungstag der Anmeldung: 25.09.1991
(73) Patentinhaber: ROTH & RAUH OBERFLÄCHENTECHNIK GmbH, 09358 Wüstenbrand (DE)
(72) Erfinder: Roth, Silvia, Dipl.-Phys., O-9274 Wüstenbrand (DE); Weber, Thomas, O-7235 Narsdorf (DE); Hammer, Klaus, Dr. sc. techn., O-9071 Chemnitz (DE)
(74) Vertreter: Erich, Dieter

(56) Entgegenhaltungen:
- EP-A- 0 286 132
- DE-A- 3 729 347

## Beschreibung

Die Erfindung betrifft ein Mikrowellen-Plasmatron zur Erzeugung eines Mikrowellen-Plasmas bei Elektronen-Zyklotronresonanz mittels einer durch ein Magnetfeld gestützten Mikrowellen-Entladung, bestehend aus einem Entladungsraum, einer Einkoppelungsanordnung für die Mikrowellen in den Entladungsraum und Magnete, vorzugsweise zum chemisch reaktiven Ätzen von insbesondere Substratoberflächen für die Mikroelektronik und Mikromechanik. Es ist bekannt, daß Mikrowellen in Verbindung mit der Elektronen-Zyklotronresonanz (ECR) zur Plasmaanregung genutzt werden. Die Entladungsräume werden dabei als Hohlraumresonatoren oder Hohlleiter in den unterchiedlichsten Konfigurationen ausgeführt. Das erforderliche statische Magnetfeld wird von einer stromdurchflossenen Spule oder mittels Permanentmagneten erzeugt. Bei den Ausführungen mit einer Spule ist es typisch, daß diese den Hohlraumresonator oder Hohlleiter kreisringfömig umschließt. Derartige Anordnungen sind in vielfältigen Ausführungsformen (z. B. in der DE-A-2 237 252, dem J.Vac. Sci. Technol. B 3 (4) (1985) 1028 und in der DD-A-248 904) beschrieben. Es ist weiter bekannt, zur Homogenisierung des Magnetfeldes zwei oder mehrere Spulen, wie es in der DE-A-3 729 347 und dem WO-A-89/04546 ist, zu verwenden.
Der Nachteil aller dieser Anordnungen ist dabei, daß für große Entladungsräume (Durchmesser bis 25 cm) Spulen für die Erzeugung des statischen Magnetfeldes benötigt werden, die räumlich groß und schwer sind und Verlustleistungen von mehreren Kilowatt haben. Diese Anordnungen bedingen meistens auch eine starke Inhomogenität der Ionendichteverteilung, so daß zur Erreichung homogener Ionenstromdichteverteilungen noch weitere Maßnahmen erforderlich werden.
Es ist weiter bekannt, die Spulen durch Permanentmagnete zu ersetzen. Die Permanentmagnete sind dann so angebracht, daß eine Vielzahl kleiner Spalten entsteht, in denen die für die ECR notwendige magnetische Flußdichte auftritt. Derartige Anordnungen sind in der US-A-4 739 170 und der DE-A-3 705 666 beschrieben. Bei diesen Ausführungen werden die großen Spulen umgangen, jedoch ist eine kontinuierliche Einstellung der magnetischen Flußdichte während des Betriebes nicht möglich.

Der Erfindung liegt die Aufgabe zugrunde, ein Mikrowellen-Plasmatron zur Erzeugung eines Mikrowellen-Plasmas bei Elektronenzyklotronresonanz, vorzugsweise zum chemisch reaktiven Ätzen von insbesondere Substratoberflächen für die Mikroelektronik und Mikromechanik zu schaffen, das bei einem einfachen technologischen Aufbau den Einsatz unterschiedlicher reaktiver Gase zur Plasmaerzeugung gestattet, wobei eine wesentliche Verkleinerung der Abmessungen für die Magnetspule und eine gleichzeitige Verringerung des vom magnetischen Fluß durchsetzten Bereiches im Plasma erreicht und die Erzeugung eines Mikrowellenplasmas in großvolumigen Entladungsräumen ermöglicht werden soll, wobei weiterhin ein Ionenstrom hoher Dichte und gleichmäßiger Dichteverteilung, insbesondere beim Einsatz reaktiver Gase extrahiert werden kann.

Erfindungsgemäß wird die Aufgabe dadurch gelöst, daß auf einem ebenen Oberflächenwellenleiter eine oder mehrere konzentrische, hohlzylinderförmige Magnete angeordnet sind, die pro Magnet von einem U-förmig ausgebildeten Mantel aus ferromagnetischem Material in der Art umschlossen werden, daß die offene Seite am Oberflächenwellenleiter anliegt und zentrisch zum hohlzylinderförmigen Magneten die Einkoppelanordnung für die Mikrowellen angebracht ist.

Zur Plasmaanregung mit elektro-magnetischen Wellen, deren Wellenlängen im Zentimeter- bis Dezimeterbereich liegen, werden geometrisch bestimmte Entladungsräume benutzt, deren Abmessungen durch die Wellenlängen vorgegeben sind. Bei Nutzung der ECR ist weiterhin zu beachten, daß ein statisches Magnetfeld erforderlich ist. Dabei muß die Flußdichte des statischen Magnetfeldes senkrecht zu einer elektrischen Feldstärkekomponente der Mikrowellen stehen. Die kontruktiven Anordnungen werden gewählt, daß ein Hohlleiter oder Hohlramresonator von einer Spule umschlossen wird.
Die Lösung nach der Erfindung nutzt vorteilhaft die Möglichkeit der Ausbreitung der Mikrowellen als Oberflächenwellen.
Es ist im Sinne der Erfindung, daß der mittlere Duchmesser d des hohlzylinderförmigen Magneten einer Wellenlänge oder einem ganzzahligen Vielfachen der Wellenlänge λ der Mikrowellen entspricht.
Die Erfindung ist ausgestaltet, wenn bei einer Anordnung von mehreren Magneten, deren mittlere Durchmesser jeweils ein ganzzahliges Vielfaches der Wellenlänge λ der Mikrowellen betragen. Eine Ausbildung der Erfindung ist es, daß die hohlzylinderförmigen Magnete Spulen sind, wobei eine Ausübungsform der Erfindung so gestaltet ist, daß die hohlzylinderförmigen Magnete Permanentmagnete sind.
Im weiteren Sinne der Erfindung ist es, daß der ebene Oberflächenwellenleiter die Deckplatte des Entladungsraumes bildet, wobei es auch vorteilhaft im Sinne der Erfindung ist, daß auf den Oberflächenwellenleiter eine dünne Isolierstoffscheibe aufgelegt ist.
Es ist Ausführungsform der Erfindung, daß der Oberflächenleiter aus einer gerippten Metallfläche gebildet ist, wobei ausbildend der Oberflächenleiter Rippen mit kleinen Abständen gegenüber der Wellenlänge aufweist.
Ausgebildet im Sinne der Erfindung ist der Oberflächenleiter, in dem er sehr dünne Rippen gegenüber dem Abstand der Rippen zueinander aufweist.

Eine sinnvolle Form der Erfindung ist es, wenn der zylindrische Entladungsraum von einer ringförmigen Scheibe abgeschlossen ist oder in einer anderen Ausbildung der zylindrische Entladungsraum von einem ebenen Extraktionssystem abgeschlossen ist.

Es ist zur vollständigen Darstellung der Erfindung auszugehen, daß Oberflächenwellenleiter Wellentypen führen, die sich entlang der Grenzschicht zwischen zwei unterschiedlichen Medien fortbewegen und bei denen sich elektrische Feldstärkekomponenten in axialer Richtung, also senkrecht zur Ausbreitungsrichtung, ausbilden. Eine spezielle Ausführungsform des Oberflächenwellenleiters ist die ebene Platte. Das Problem der Wellenausbreitung an einer ebenen metallischen Platte in einem gasförmigen Medium läßt sich in der Art vereinfachen, daß zwei Medien mit vollkommen unterschiedlicher elektrischer Dielektrizitätskonstante ε , elektrischer Leitfähigkeit δ bei ungefähr gleicher Permeabilität » angenommen werden können. In diesem Fall entstehen elektrische Feldstärkekomponenten senkrecht zur Leiteroberfläche mit cosinusförmigem Verlauf. Im Abstand λ/2 von der Einkoppelstelle bildet sich ein Maximum der elektrischen Feldstärkekomponente aus. Durchläuft die elektrische Feldstärkekomponente jetzt ein statisches aber inhomogenes Magnetfeld B mit kreisabschnittförmiger Konfiguration, entstehen Verhältnisse, bei denen Linien des statischen magnetischen Flusses und der elektrischen Feldstärke senkrecht aufeinander stehen. In einer Vakuumkammer können unter dieser Voraussetzung Elektronen so beschleunigt werden, daß ihre Gyrationsfrequenz und die Frequenz der elektromagnetischen Wellen gleich sind, so daß ECR auftritt. Dabei entstehen optimale Bedingungen für die ECR im Bereich der höchsten elektrischen Feldstärkekomponente, also λ/2 von der Einkoppelstelle entfernt. Neben der ECR können auf Grund der starken Inhomogenität des statischen Magnetfeldes noch weitere hybride Resonanzen entstehen. Unter den Bedingungen der ECR sind die bekannten günstigen Voraussetzungen für eine Plasmaanregung gegeben.

Die angegebenen physikalischen Zusammenhänge liegen wie dargestellt der Erfindung zugrunde. Der Einsatz des Oberflächenwellenleiters mit aufgesetzten Magneten ermöglicht vorteilhaft eine wesentliche Verkleinerung des Magneten. Ihr mittlerer Durchmesser d entspricht ungefähr der Wellenlänge λ. Der magnetische Fluß kann bis auf einen Ringspalt am Oberflächenwellenleiter in einem Eisenkreis geführt werden.

Vorteilhaft wird durch diese Anordnung eine relativ gleichmäßige Ionendichteverteilung im Entladungsraum erreicht, weil es zu einer gleichmäßigen Diffusion nach allen Seiten aus dem aktiven Bereich des Plasmas kommt.

Da in dem angegebenen Mikrowellen-Plasmatron die magnetischen Flußdichte in axialer Richtung sehr schnell abnimmt, ist diese Anordnung auch für eine flache Bauweise des Entladungsraumes und für Ionenquellen vorteilhaft geeignet. Es entfällt die störende Beeinflussung des Plasmas im Bereich des Extraktionssystems der Ionenquellen durch ein äußeres statisches Magnetfeld, wobei für die Einkopplung der Mikrowellen in den Entladungsraum unterschiedliche Ausführungen wie Koppelstift, Koppelschleife oder Koppelloch verwendet werden können. Zu bevorzugen sind aber solche Ausführungsformen, bei denen die elektrische Feldstärkekomponente zentral ein Maximum hat, wie z. B. beim Koppelstift oder der E₀₁-Welle im Rundhohlleiter.

Die Erfindung soll anhand eines Ausführungsbeispieles näher erläutert werden. In der zugehörigen Zeichnung zeigen:
Fig. 1: ein Mikrowellen-Plasmatron mit einem Magneten,
Fig. 2: ein Mikrowellen-Plasmatron mit mehreren Magneten,
Fig. 3: ein Mikrowellen-Plasmatron,
Fig. 4: ein Mikrowellen-Plasmatron mit einer Isolierstoffscheibe,
Fig. 5: eine gerippte Metallfläche als Oberflächenwellenleiter,
Fig. 6: eine Mikrowellen-Plasmatron-Ionenquelle.

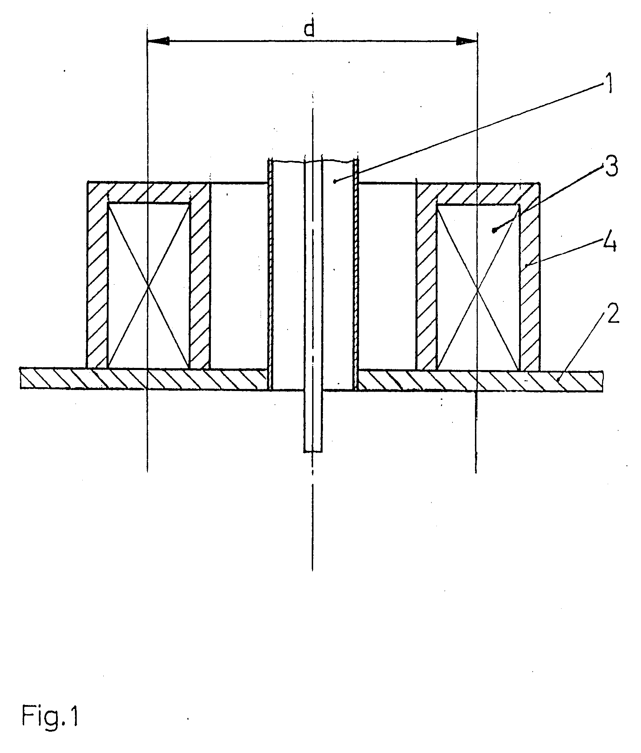

In Fig. 1 ist der prinzipielle Aufbau des Mikrowellen-Plasmatrons gezeigt. Die Mikrowellen werden über die Einkoppelanordnung 1 auf den Oberflächenwellenleiter 2, der von einer ebenen Platte gebildet wird, übertragen. Sie breiten sich am Oberflächenwellenleiter 2 radial, mit einer axialen elektrischen Feldstärkekomponente aus. Vom hohlzylinderförmigen Magneten 3 wird ein statisches Magnetfeld erzeugt, das in einem U-förmigen Mantel 4 aus Eisen geführt wird und im Ringspalt angenähert einen kreisabschnittförmigen Verlauf hat.

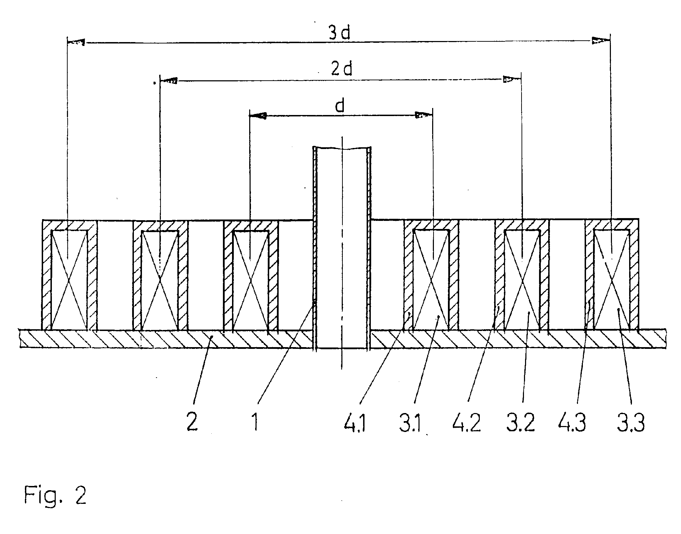

Fig. 2 zeigt den schematischen Aufbau eines Mikrowellen-Plasmatrons mit mehreren Magneten 3.1; 3.2; 3.3 und einem zugehörigen Mantel 4.1; 4.2; 4.3. Als Einkoppelanordnung 1 für die Mikrowellen wird in diesem Fall ein Rundhohlleiter vom E₀₁-Typ verwendet. Die Magneten 3.1; 3.2; 3.3 haben immer einen um eine Wellenlänge λ größeren mittleren Durchmesser d. Da sich der elektrische Feldstärkeverlauf der Mikrowellen periodisch nach außen hin wiederholt, wird das Plasma an mehreren Stellen angeregt. Eine derartige Ausführung des Mikrowellen-Plasmatrons ist besonders gut für großräumige Anordnungen geeignet.

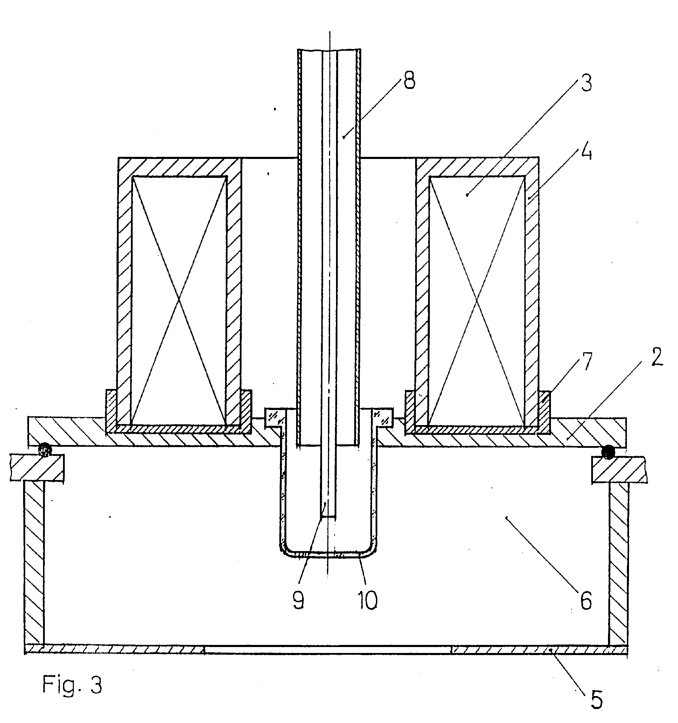

In den Anordnungen nach Fig. 3 bis 6 wird für die Bestimmung der geometrischen Abmessungen eine Frequenz der Mikrowellen von 2,45 GHz zugrunde gelegt, das entspricht einer notwendigen mittleren magnetischen Flußdichte des statischen Magnetfeldes von ca. 0,085 T für die ECR. Der Oberflächenwellenleiter 2 wird von einer runden ebenen Platte gebildet, die gleichzeitig eine Deckplatte des Entladungsraumes ist.

Die Deckplatte ist im Ausführungsbeispiel aus Aluminium gefertigt. Auf der Deckplatte aufgesetzt ist der Magnet 3, der hier als Spule ausgeführt ist. Die Spule hat einen mittleren Durchmesser d von 12,5 cm was in etwa der Wellenlänge λ der Mikrowellen entspricht. Die Breite ist mit 3 cm ca. 1/4 λ. Umschlossen wird die Spule von einem U-förmigen Mantel 4 aus Eisen. Die Spule und der Mantel 4 sind in die Deckplatte versenkt eingesetzt, damit sich die Bereiche der höchsten magnetischen Flußdichte unmittelbar im Entladungsraum 6 ausbilden. Zwischen der Spule, dem Mantel 4 und der Deckplatte ist eine Isolation 7 eingebracht, so daß bei entsprechender Isolierung des Entladungsraumes 6 das Plasma an H ochspannungspotential angeschlossen werden kann, währenddessen die Spule auf Erdpotential bleibt. Die Mikrowellen werden über die Koaxialleitung 8 mit verlängertem Innenleiter als Koppelstift 9 in den Entladungsraum 6 eingekoppelt. Der Quarzglasbecher 10 ist für die Mikrowellen durchlässig, übernimmt aber die Vakuumabtrennung des Entladungsraumes 6 von der Einkoppelstelle. Angebaut wird das Mikrowellen-Plasmatron an einen Entladungsraum 6 mit einem Durchmesser von 250 mm und einer Höhe von 150 mm. Nach unten hin wird der Entladungsraum 6 von der ringförmigen Scheibe 5 abgeschlossen, wodurch eine Verbesserung des Zündverhaltens erreicht wird. In einem Druckbereich von 10⁻² Pa wird das Plasma bei Mikrowellenleistungen von 400 W sicher gezündet, wobei unabhängig von der Gasart Ionendichten zwischen 3...10 . 10¹⁰ cm ⁻³ bestimmt werden. Aus dem Plasma konnten Ionenströme mit homogenen Stromdichteverteilungen bis 3 mA/cm² über 6 Zoll Durchmesser extrahiert werden.

Stromdichten bis 1,5 mA/cm² werden erreicht, wenn für den Magneten 3 an Stelle der Spulen bei gleichem Aufbau Permanentmagnete verwendet werden.

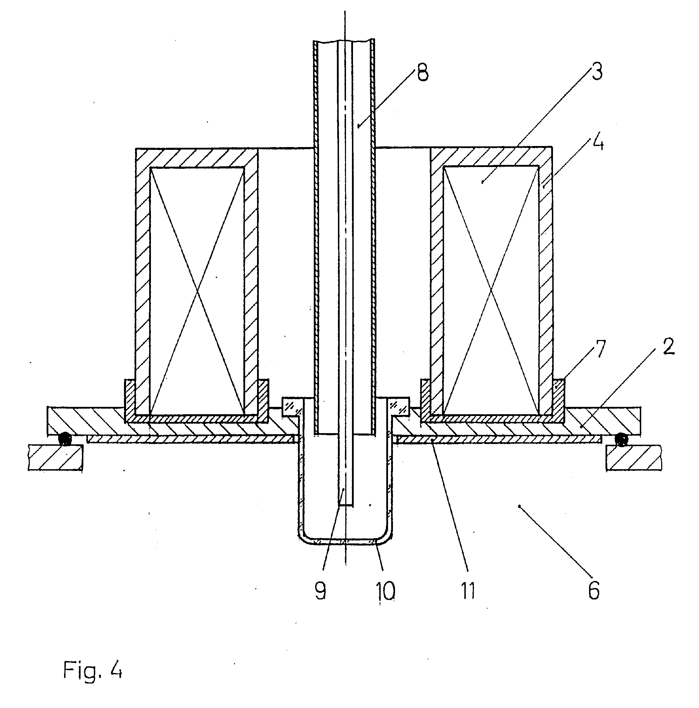

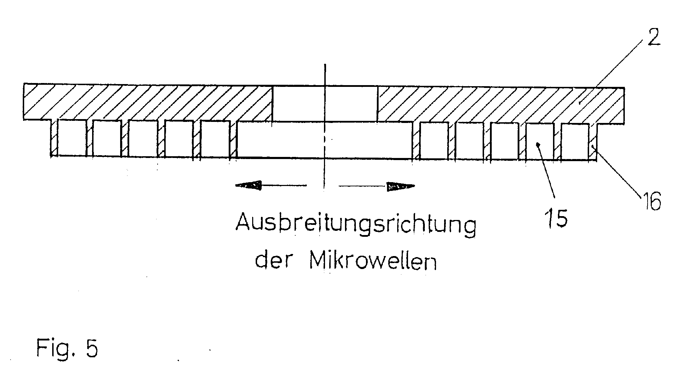

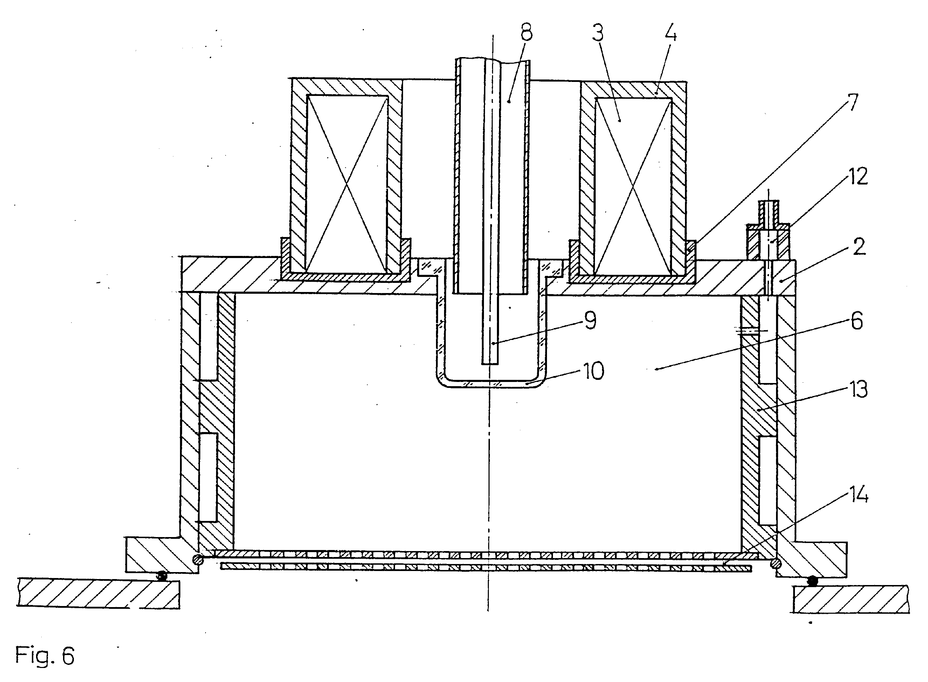

In einer zweiten Ausführung des Mikrowellen-Plasmatrons, wie sie in Fig. 4 dargestellt ist, ist im Entladungsraum 6 auf die Deckplatte eine dünne Isolierstoffscheibe 11 aufgelegt. Die Isolierstoffscheibe 11 darf in dieser Anordnung nur eine Dicke von wenigen Millimeter haben, als Material wird Al₂O₃_Keramik verwendet. Die Deckplatte mit der Isolierstoffscheibe 11 bildet jetzt den Oberflächenwellenleiter 2. In dieser Anordnung wird die axiale Ausbreitung der elektrischen Feldstärkekomponente eingeschränkt, und es werden höhere elektrische Feldstärken im oberflächennahen Bereich des Oberflächenwellenleiters 2 erreicht. Eine ähnliche Wirkung entsteht dann, wenn die Deckplatte eine Struktur erhält, wie sie in Fig. 5 gezeigt ist. Sind die Rippen 16 sehr dünn und ist ihr Abstand 15 klein gegenüber der Wellenlänge λ, wirkt die gerippte Metallfläche als Oberflächenwellenleiter 2. In Fig. 6 ist die Anwendung eines Mikrowellen-Plasmatrons zur Plasmaanregung in einer Ionenquelle gezeigt. Der Entladungsraum 6 hat in der angegebenen Ionenquelle einen Durchmesser von ca. 200 mm. Der Gaseinlaß 12 ist isoliert über der Deckplatte angebracht. Ausgekleidet ist der Entladungsraum 6 mit Graphiteinsätzen 13, an denen auch das Extraktionssystem 14 befestigt wird. Bei einer Höhe des Entladungsraumes 6 von ca. 110 mm ist die magnetische Flußdichte im Bereich des Extraktionssystems 14 so niedrig (< 0,01 T), daß keine störende Beeinflussung der Ionenextraktion auftritt. Mit dieser Anordnung werden bei Extraktionsspannungen von 1,5 kV Ionenstrahlen mit Ionenstromdichten von 0,6 mA/cm² erreicht.

### Aufstellung der verwendeten Bezugszeichen

- 1: Einkoppelanordnung
- 2: Oberflächenwellenleiter
- 3: Magnet
- 3.1: Magnet
- 3.2: Magnet
- 3.3: Magnet
- 4: Mantel
- 4.1: Mantel
- 4.2: Mantel
- 4.3: Mantel
- 5: ringförmige Scheibe
- 6: Entladungsraum
- 7: Isolation
- 8: Koaxialleitung
- 9: Koppelstift
- 10: Quarzglasbecher
- 11: Isolierstoffscheibe
- 12: Glaseinlaß
- 13: Graphiteinsätze
- 14: Extraktionssystem
- 15: Abstand der Rippen
- 16: Rippen

- d: Durchmesser
- 3 d: Durchmesser
- 2 d: Durchmesser

## Patentansprüche

1. Mikrowellen-Plasmatron zur Erzeugung einer durch ein Magnetfeld gestützten Mikrowellen-Entladung, bestehend aus einem Entladungsraum, einer Einkoppelanordnung für die Mikrowellen in den Entladungsraum und Magnete, **dadurch gekennzeichnet,** daß auf einem ebenen Oberflächenwellenleiter (2) ein oder mehrere konzentrische hohlzylinderförmige Magnete (3; 3.1; 3.2; 3.3) angeordnet sind, die von einem U-förmig ausgebildeten Mantel (4; 4.1; 4.2; 4.3) pro Magnet aus ferromagnetischem Material in der Art umschlossen sind, daß die offene Seite am Oberflächenwellenleiter (2) anliegt, und zentrisch zum hohlzylinderförmigen Magneten (3) die Einkoppelanordnung (1) für die Mikrowellen angebracht ist.

2. Mikrowellen-Plasmatron nach Anspruch 1, **dadurch gekennzeichnet,** daß der mittlere Durchmesser (d) des hohlzylinderförmigen Magneten (3) einer Wellenlänge oder einem ganzzahligen Vielfachen der Wellenlänge λ der Mikrowellen entspricht.

3. Mikrowellen-Plasmatron nach Anpruch 1, **dadurch gekennzeichnet,** daß bei Anordnung mehrerer Magnete (3.1; 3.2; 3.3), deren mittlere Durchmesser jeweils ein ganzzahliges Vielfaches der Wellenlänge λ der Mikrowellen beträgt.

4. Mikrowellen-Plasmatron nach Anspruch 1 oder 3, **dadurch gekennzeichnet,** daß die hohlzylinderförmigen Magnete (3; 3.1; 3.2; 3.3) Spulen sind.

5. Mikrowellen-Plasmatron nach Anspruch 1 oder 3, **dadurch gekennzeichnet,** daß die hohlzylinderförmigen Magnete (3; 3.1; 3.2; 3.3) Permanentmagnete sind.

6. Mikrowellen-Plasmatron nach den Ansprüchen 1 bis 5, **dadurch gekennzeichnet,** daß der ebene Oberflächenwellenleiter (2) als Deckplatte des Entladungsraumes (6) ausgebildet ist.

7. Mikrowellen-Plasmatron nach den Ansprüchen 1 bis 6, **dadurch gekennzeichnet,** daß auf den Oberflächenwellenleiter (2) eine dünne Isolierstoffscheibe (11) aufgelegt ist.

8. Mikrowellen-Plasmatron nach Anspruch 1, **dadurch gekennzeichnet,** daß der Oberflächenleiter (2) aus einer gerippten Metallfläche gebildet ist.

9. Mikrowellen-Plasmatron nach Anspruch 8, **dadurch gekennzeichnet,** daß der Oberflächenleiter (2) Rippen (16) mit kleinen Abständen (15) gegenüber der Wellenlänge aufweist.

10. Mikrowellen-Plasmatron nach Anspruch 8 oder 9, **dadurch gekennzeichnet,** daß der Oberflächenleiter (2) sehr dünne Rippen (16) gegenüber dem Abstand (15) der Rippen (16) zueinander aufweist.

11. Mikrowellen-Plasmatron nach den vorhergehenden Ansprüchen, **dadurch gekennzeichnet,** daß der zylindrische Entladungsraum (6) von einer ringförmigen Scheibe (5) abgeschlossen ist.

12. Mikrowellen-Plasmatron nach den Ansprüchen 1 bis 9, **dadurch gekennzeichnet,** daß der zylindrische Entladungsraum (6) von einem ebenen Extraktionssystem (14) abgeschlossen ist.

## Claims

1. A microwave plasmatron for producing a microwave discharge supported by a magnetic field, consisting of a discharge chamber, a focusing arrangement for the microwaves into the discharge chamber and magnets,
**characterised in that** one or more concentric hollow-cylindrical magnets (3; 3.1; 3.2; 3.3) are disposed on a plane surface waveguide (2), which magnets are surrounded by one U-shaped shell (4; 4.1; 4.2; 4.3) per magnet made from ferromagnetic material so that the open side abuts the surface waveguide (2), and the focusing arrangement (1) for the microwaves is mounted centrally in relation to the hollow cylindrical magnet (3).

2. A microwave plasmatron according to Claim 1,
**characterised in that** the mean diameter (d) of the hollow-cylindrical magnet (3) corresponds to a wavelength or an integral multiple of the wavelength λ of the microwaves.

3. A microwave plasmatron according to Claim 1,
**characterised in that** when several magnets (3.1; 3.2; 3.3) are provided, their mean diameter is respectively an integral multiple of the wavelength λ of the microwaves.

4. A microwave plasmatron according to Claim 1 or 3,
**characterised in that** the hollow-cylindrical magnets (3; 3.1; 3.2; 3.3) are coils.

5. A microwave plasmatron according to Claim 1 or 3,
**characterised in that** the hollow-cylindrical magnets (3; 3.1; 3.2; 3.3) are permanent magnets.

6. A microwave plasmatron according to Claims 1 to 5,
**characterised in that** the plane surface waveguide (2) is constructed as a cover plate for the discharge chamber (6).

7. A microwave plasmatron according to Claims 1 to 6,
**characterised in that** a thin insulating disc (11) is laid on the surface waveguide (2).

8. A microwave plasmatron according to Claim 1,
**characterised in that** the surface waveguide (2) is formed from a ribbed metal surface.

9. A microwave plasmatron according to Claim 8,
**characterised in that** the surface waveguide (2) has ribs (16) with small spacings (15) in comparison with the wavelength.

10. A microwave plasmatron according to Claim 8 or 9,
**characterised in that** the surface waveguide (2) has very thin ribs (16) in comparison with the spacing (15) of the ribs (16).

11. A microwave plasmatron according to the preceding Claims,
**characterised in that** the cylindrical discharge chamber (6) is closed by an annular disc (5).

12. A microwave plasmatron according to Claims 1 to 9,
**characterised in that** the cylindrical discharge chamber (6) is closed by a plane extraction system (14).

## Revendications

1. Plasmatron à micro-ondes destiné à engendrer une décharge de micro-ondes assistée par champ magnétique, se composant d'un espace de décharge, d'un agencement servant à coupler les micro-ondes dans l'espace de décharge et d'aimants, caractérisé en ce qu'un ou plusieurs aimants concentriques en forme de cylindre creux (3; 3.1; 3.2; 3.3), qui sont entourés par une enveloppe configurée en U (4; 4.1; 4.2; 4.3) par aimant en matière ferromagnétique, sont disposés sur un guide plan (2) d'ondes de surface d'une manière telle que le côté ouvert repose sur le guide (2) d'ondes de surface et l'agencement de couplage (1) de micro-ondes est monté au centre par rapport à l'aimant (3) en forme de cylindre creux.

2. Plasmatron à micro-ondes selon la revendication 1, caractérisé en ce que le diamètre moyen (d) de l'aimant (3) en forme de cylindre creux correspond à une longueur d'onde ou à un multiple entier de la longueur d'onde des micro-ondes.

3. Plasmatron à micro-ondes selon la revendication 1, caractérisé en ce que, lorsque plusieurs aimants (3.1; 3.2; 3.3) sont disposés, le diamètre moyen de chacun correspond à un multiple entier de la longueur d'onde des micro-ondes.

4. Plasmatron à micro-ondes selon la revendication 1 ou 3, caractérisé en ce que les aimants en forme de cylindres creux (3.1; 3.2; 3.3) sont des bobines.

5. Plasmatron à micro-ondes selon la revendication 1 ou 3, caractérisé en ce que les éléments en forme de cylindres creux (3.1; 3.2; 3.3) sont des aimants permanents.

6. Plasmatron à micro-ondes selon l'un des revendications 1 à 5, caractérisé en ce que le guide (2) d'ondes de surface est réalisé sous la forme d'une plaque de recouvrement de l'espace de décharge (6).

7. Plasmatron à micro-ondes selon l'une des revendications 1 à 6, caractérisé en ce qu'un mince disque (11) en matière isolante est posé sur le guide (2) d'ondes de surface.

8. Plasmatron à micro-ondes selon la revendication 1, caractérisé en ce que le guide (2) d'ondes de surface est constitué d'une surface mécanisme nervurée.

9. Plasmatron à micro-ondes selon la revendication 8, caractérisé en ce que le guide (2) d'ondes de surface comporte des nervures (16) dont les distances (15) sont faibles par rapport à la longueur d'onde.

10. Plasmatron à micro-ondes selon la revendication 8 ou 9, caractérisé en ce que le guide (2) d'ondes de surface comporte des nervures (16) d'une épaisseur très faible par rapport à la distance (15) entre les nervures (16).

11. Plasmatron à micro-ondes selon l'une quelconque des revendications précédentes, caractérisé en ce que l'espace cylindrique (6) de décharge est fermé par un disque annulaire (5).

12. Plasmatron à micro-ondes selon l'une des revendications 1 à 9, caractérisé en ce que l'espace cylindrique (6) de décharge est fermé par un système plan (14) d'extraction.
